Europäisches Patentamt

European Patent Office

Office européen des brevets

(11) Veröffentlichungsnummer: **0 270 703 B1**

(12) **EUROPÄISCHE PATENTSCHRIFT**

(45) Veröffentlichungstag der Patentschrift: **18.12.91**

(51) Int. Cl.⁵: **H01L 21/82**, H01L 21/225

(21) Anmeldenummer: **86117352.4**

(22) Anmeldetag: **12.12.86**

(54) **Verfahren zum Herstellen einer monolithisch integrierten Schaltung mit mindestens einem bipolaren Planartransistor.**

(43) Veröffentlichungstag der Anmeldung:
**15.06.88 Patentblatt 88/24**

(45) Bekanntmachung des Hinweises auf die
Patenterteilung:
**18.12.91 Patentblatt 91/51**

(84) Benannte Vertragsstaaten:
**DE FR GB IT NL**

(56) Entgegenhaltungen:
**EP-A- 0 040 032**
**EP-A- 0 071 665**
**EP-A- 0 093 786**
**EP-A- 0 122 313**
**EP-A- 0 139 266**

(73) Patentinhaber: **Deutsche ITT Industries GmbH**
**Hans-Bunte-Strasse 19 Postfach 840**
**W-7800 Freiburg i.Br.(DE)**

(72) Erfinder: **Blossfeld, Lothar, Dipl.-Phys.**
**Waldstrasse 23**
**W-7800 Freiburg-Hochdorf(DE)**

## Beschreibung

Die Erfindung beschäftigt sich mit einem Verfahren, welches zum Herstellen von monolithisch integrierten Höchstfrequenzschaltungen geeignet ist, welche zumindest je einen integrierten bipolaren Planartransistor enthalten, also auch noch weitere integrierte Bauelemente, wie Isolierschicht-Feldeffekttransistoren, integrierte Kapazitäten oder auch integrierte Widerstände enthalten können. Das Verfahren nach der Erfindung wie auch die Erörterung des Standes der Technik wird jedoch zur Erleichterung des Verständnisses und zur Vereinfachung der Beschreibung auf ein Verfahren zur Herstellung einer monolithisch integrierten Schaltung mit mindestens einem bipolaren Planartransistor bezogen. Darin ist also keine Einschränkung zu sehen, zumal es seit langem üblich ist, monolithisch integrierte Schaltungen an einer in die einzelnen Schaltungen zu zerteilenden größeren Halbleiterplatte gemeinsam herzustellen und erst abschließend einzeln zu verkapseln.

Ein Verfahren solcher Art ist in den Offenlegungsschriften DE-A 32 43 059 oder DE-A 31 29 539 beschrieben. Dabei werden dotierte polykristalline Silicium-Schichten verwendet, um in selbstjustierender Weise die Basiskontaktierungszone mit ihrer Basiselektrode und die Emitterzone mit ihrer Emitterelektrode in unmittelbarer Nähe zueinander herzustellen. Damit wird ein sehr geringer Basiszuleitungswiderstand und eine relativ hohe Arbeitsgeschwindigkeit erzielt. Außerdem hat ein solches selbstjustierendes Verfahren grundsätzlich den Vorteil, daß Sicherheitsabstände bei den photolithographischen Prozessen auf ein Minimum gebracht werden können, so daß die seitlichen Abmessungen der bipolaren Planartransistoren verringert werden können.

Ein Nachteil des Verfahrens der oben genannten DE-A 31 29 539 besteht darin, daß ein aufwendiger Epitaxieprozeß angewendet wird, der die Ausbeute erfahrungsgemäß kleinhält. Ein Nachteil des Verfahrens nach der genannten DE-A 32 43 059 besteht darin, daß die Überlappungskapazität zwischen der Emitterelektrode und der Basiselektrode die Arbeitsgeschwindigkeit begrenzt.

Die Erfindung geht von dem Verfahren der EP-A-0 122 313 aus, das die vorstehend genannte Nachteile im wesentlichen überwindet, wobei der Gedanke der DE-AS 31 29 539 aufgegriffen wird, die Bahnwiderstände der polykristallinen Silicium-Elektroden, welche in verbindende Leiterbahnen übergehen, mit oberflächlichen Silicidschichten zu versehen, um die Zuleitungswiderstände zu erniedrigen. Dies hat ebenfalls eine Erhöhung der Arbeitsgeschwindigkeit der monolithisch integrierten Schaltung zur Folge.

Während sich die vorstehend genannten DE-Offenlegungsschriften nicht mit der Herstellung der Kollektorelektrode beschäftigen, wird bei einer Ausführungsform des Verfahrens nach der EP-A-0 122 313 zwar die Kollektorkontaktierungszone selbstausrichtend zur Emitterzone und zur Basiskontaktierungszone hergestellt. Das gilt aber nicht für die Herstellung der Kontakte an den zu kontaktierenden Zonen.

Bei dem bekannten Verfahren der vorstehend genannten EP-A-0 122 313 zum Herstellen einer monolithisch integrierten Schaltung mit mindestens einem bipolaren Planartransistor bildet dessen an einer Hauptfläche eines plattenförmigen Halbleitersubstrats liegende Kollektorzone an dieser Oberflächenseite innerhalb der Öffnung einer Feldoxidschicht einen Kollektorbereich. Zur Herstellung von Emitterzone von Basiszone und Kollektorkontaktierungszone selbstausrichtend zueinander wird der Emitterbereich mit einem Oxidationsmaskierungsschichtteil einer Oxidationsmaskierungsschicht solcher Dicke bedeckt, daß diese bei einem Ionenimplantationsprozeß relativ hoher Energie von Dotierungen der Basiszone durchdrungen und bei einem anderen Ionenimplantationsprozeß relativ niedriger Energie von Dotierungen der Basiszone maskiert wird.

Nach den Implantationsprozessen, welche unter Verwendung eine den Basisbereich definierenden Implantationsmaske erfolgen, wird die freiliegende Halbleiteroberfläche unter Bildung eines den Emitterbereich umgebenden Oxidstreifens thermisch oxidiert und danach der erste Oxidationsmaskierungsschichtteil entfernt. Schließlich wird die Hauptfläche mit einer Fremdoxidschicht bedeckt, welche Kontaktöffnungen zu den Zonen aufweist, die durch die Kontaktöffnungen hindurch mittels Elektroden kontaktiert werden. Die Kontaktierung der Zonen erfolgt, wie es bei planaren integrierten Schaltungen üblich ist, über Leiterbahnen, welche auf thermisch erzeugten Oxidschichten und/oder auf einer Fremdoxidschicht verlaufen und welche durch Kontaktöffnungen in diesen isolierenden Schichten hindurch die Zonen oder auch bereits an den Zonen angebrachte Elektroden kontaktieren.

Zur Herstellung der Kontaktierungsöffnungen in den Isolierschichten ist ein besonderer photolithographischer Ätzprozeß mit einem bestimmten seitlichen Sicherheitsabstand relativ zu den zu kontaktierenden Zonen erforderlich, um den Kurzschluß eines pn-Übergangs an der Halbleiteroberfläche auszuschließen.

Daraus ergibt sich die der Erfindung zugrundeliegende Aufgabe der Angabe eines mit dem Verfahren der oben genannten EP-A-0 122 313 kompatiblen Verfahrens, welches die selbstausrichtende Herstellung sämtlicher Zonen des Planartransistors zu ihren Kontaktierungszonen bzw. Elektroden erlaubt. Diese Aufgabe wird bei dem bekannten Verfahren gemäß dem Oberbegriff des Anspruchs 1 erfindungsgemäß durch die in seinem kennzeichnenden Teil angegebenen Prozesse gelöst.

Die Lösung der genannten Aufgabe liegt im Rahmen der Lösung der Rahmenaufgabe einer Erhöhung der Arbeitsgeschwindigkeit. Zur Lösung dieser Rahmenaufgabe liefert das Verfahren der Erfindung insofern einen Beitrag, als die niederohmige Kontaktierung der Basiszone in unmittelbarer Nähe der Emitterzone ohne Einhaltung eines Sicherheitsabstandes möglich ist.

Das Verfahren der Erfindung hat also den weiteren Vorteil, daß lediglich eine einheitlich dotierte polykristalline Si-Schicht aufgebracht wird, aus der sowohl die Emitterelektrode als auch die Kollektorelektrode einschließlich der anschließenden Leiterbahnen herausgeätzt werden können.

Diesen Vorteil weisen weder die Verfahren der obengenannten DE-A-21 29 539 und DE-A-32 43 059, noch das Verfahren der älteren Druckschrift EP-A-0 239 652 auf, die für die benannten Vertragsstaaten zum Stand der Technik aufgrund Art. 54(3) EPÜ gehört, wie er im Oberbegriff des Anspruchs 1 angegeben ist. Bei diesem Verfahren des älteren Vorschlages werden aber ebenfalls nacheinander zwei polykristalline Schichten aufgebracht.

Nach einer ersten Ausführungsform des Verfahrens der Erfindung wird eine polykristalline Siliciumschicht aufgebracht, welche Dotierungen vom Leitungstyp der Emitterzone enthält, dessen Leitungstyp dem der Kollektorzone entspricht. Nach dem herausätzen der Elektroden wird die an die Emitterelektrode angrenzende Emitterzone aus der Emitterelektrode diffundiert und entsprechend aus der Kollektorelektrode eine angrenzende Kollektorkontaktierungszone.

Dagegen wird nach einem alternativen zweiten Ausführungsbeispiel des Verfahrens nach der Erfindung vor dem Aufbringen der Schichtenfolge, aus der die Emitterelektrode und die Kollektorelektrode herausgeätzt wird, in die freiliegende Teile des Kollektorbereichs und des Emitterbereichs, welche freien Teile sich an die Emitterelektrode bzw. die Kollektorelektrode anschließen, Ionen vom Leitungstyp der Emitterzone implantiert.

Das Verfahren der Erfindung läßt sich, wie das damit kompatible Verfahren der EP-A-0 122 313 ohne weiteres derartig weiterbilden, daß sowohl mindestens ein P-Kanal-Isolierschicht-Feldeffekttransistor als auch mindestens ein N-Kanal-Isolierschicht-Feldeffekttransistor eines CMOS-Schaltkreises in die Integration einbezogen werden können.

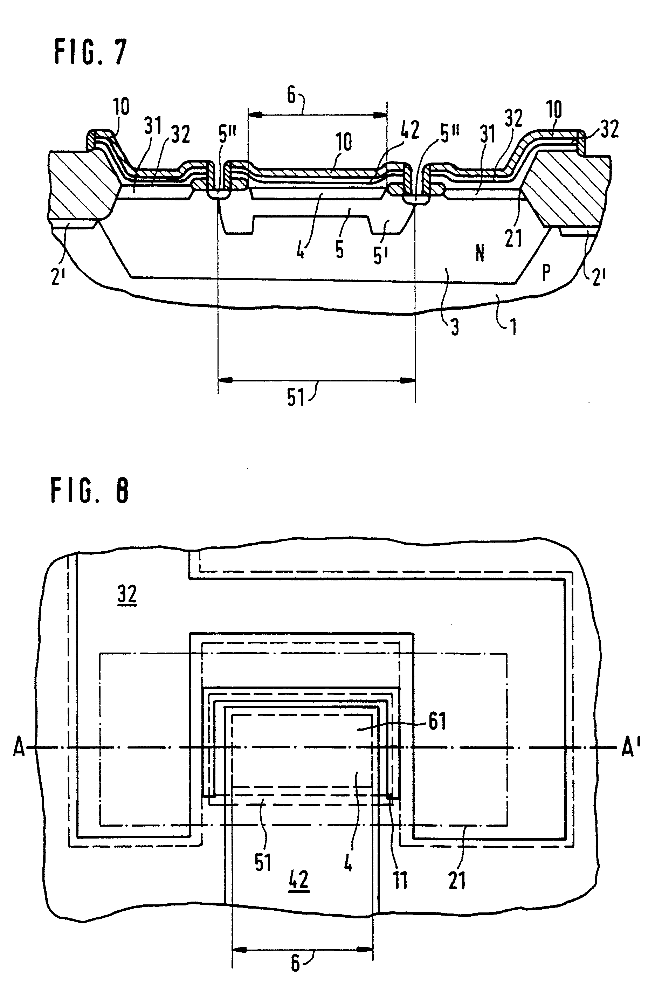

Vorzugsweise werden beim Verfahren der Erfindung Leitbahnenmuster hergestellt, welche die Emitterelektroden und/oder die Kollektorelektroden enthalten, wie es aus der Fig. 8 ersichtlich ist.

Damit ist eine weitere Erhöhung der Arbeitsgeschwindigkeit erzielbar, da der Bahnwiderstand der Leiterbahnen wesentlich gegenüber dem Bahnwiderstand von Leiterbahnen allein aus dotiertem polykristallinem Silicium vermindert ist.

Das Verfahren nach der Erfindung und seine Vorteile werden im folgenden anhand der Zeichnung erläutert:

Fig. 1 bis 3 zeigen die Teilschnittansichten einer einen Bipolartransistor und einen CMOS-Schaltkreis enthaltenden monolithisch integrierten Schaltung, welche zur Erläuterung von aufeinanderfolgenden Arbeitsgängen entsprechend dem bekannten Stand der Technik dienen,

Fig. 4 veranschaulicht den ersten Arbeitsprozeß entsprechend dem Verfahren nach der Erfindung, und

Fig. 5 bis 7 sind Querschnittsansichten, jedoch lediglich durch den Bipolartransistor der Fig. 1 bis 3, und veranschaulichen weitere auf die Arbeitsprozesse der Fig. 1 bis 3 folgenden Prozesse

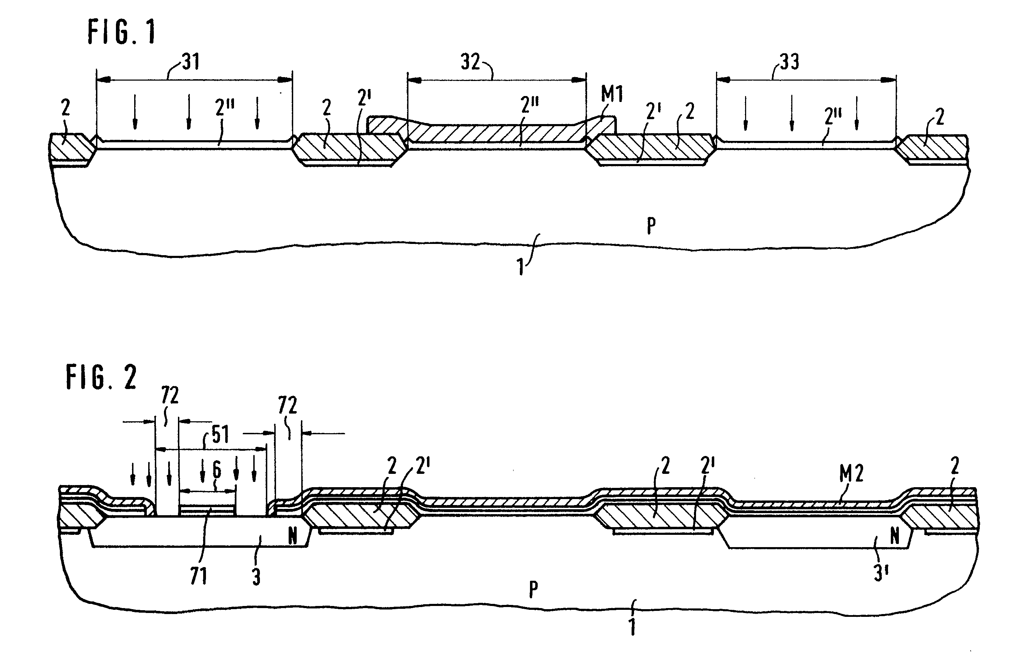

Die Fig. 1 bis 4 der Zeichnung beziehen sich auch auf eine Weiterbildung des Verfahrens nach der Erfindung im Hinblick auf das damit kompatible Verfahren der bereits erwähnten EP-A-0 122 313. Nach dieser Weiterbildung kann eine monolithisch integrierte Schaltung hergestellt werden, die nicht nur einen Planartransistor, sondern auch noch einen Isolierschicht-Feldeffekttransistor enthält, die gleichzeitig an der einen Hauptfläche des Halbleitersubstrats hergestellt werden. In gleicher Weise können selbstverständlich noch weitere bipolare Planartransistoren und weitere Isolierschicht-Feldeffekttransistoren in demselben Halbleitersubstrat hergestellt werden. Die Figuren der Zeichnung entsprechend im übrigen der üblichen Darstellung in Schrägschnittansichten, d.h. einer starken Überhöhung des in die Tiefe des Halbleitersubstrats sich erstreckenden Maßstabes.

In die Fig. 1 bis 4 ist der bipolare Planartransistor im Substratbereich 31, der N-Kanal-Isolierschicht-Feldeffekttransistor im Substratbereich 32 und der P-Kanal-Isolierschicht-Feldeffekttransistor im Substratbereich 33 angeordnet, wie die Fig. 1 veranschaulicht. Die Substratbereiche decken sich mit Öffnungen innerhalb der Feldoxidschicht 2, der auf der Substratseite eine $p^+$-leitende Kanalunterbrecherzone 2' vorgelagert ist. Die Herstellung der Feldoxidschicht 2 erfolgt unter Verwendung der Oxidationsmaskierungsschichten 2", beispielsweise aus einer Schichtenfolge Siliciumdioxid-Siliciumnitrid, indem nach Strukturierung der Oxidationsmaskierungsschicht eine Ionenimplantation zum Einführen der Dotierungen der Kanalunterbrecherzone 2' angewendet wird und anschließend eine thermische Oxidation erfolgt.

Stellvertretend für sämtliche Bereich der N-Kanal-Feldeffekttransistoren der integrierten Festkörperschaltung wird anschließend der Bereich 32 des N-Kanal-Feldeffekttranistors mittels der Implantationsmaske M1 aus Photolack maskiert. Mittels eines Ionenimplantationsprozesses, wie er durch die Pfeile der Fig. 1 angedeutet ist, werden n-dotierende Verunreinigungen der Kollektorzone des bipolaren Planartransistors und der Substratzone des P-Kanal-Isolierschicht-Feldeffekttransistors durch die relativ dünnen Oxidationsmaskierungsschichtteile 2″ der Bereiche 31 und 33 in die Substratfläche eingeführt. Dabei maskiert die relativ dicke Feldoxidschicht 2 und die Implantationsmaske M1.

Nach sorgfältiger Entfernung der Implantationsmaske M1 und einer Aktivierung der implantierten Ionen bei einem Hochtemperaturprozeß, bei dem die Dotierungen weiter in den Halbleiterkörper eindringen, wird die Kollektorzone 3 des bipolaren Planartransistors und die Substratzone 3′ gebildet, wie die Fig. 2 zeigt.

Anschließend wird gemäß der Fig. 2 der Emitterbereich 6 des bipolaren Planartransistors mit einem Oxidationsmaskierungsschichtteil 71 abgedeckt, indem die von der Implantationsmaske M1 befreite Oberfläche der Anordnung der Fig. 1 mit einer Oxidationsmaskierungsschicht bedeckt wird, aus der unter Anwendung eines photolithographischen Ätzprozesses der Oxidationsmaskierungsschichtteil 71 herausgeätzt wird. Es ist günstig, die Oxidationsmaskierungsschicht bzw. den Oxidationsmaskierungsschichtteil 71 in Form einer Schichtenfolge aus einer unteren Siliciumdioxidschicht und einer oberen Siliciumnitridschicht auszubilden, wie in der Fig. 2 angedeutet ist. Vorzugsweise bleibt am Rande der Kollektorzone 3 ebenfalls ein Oxidationsmaskierungsschichtteil 72 erhalten, der den Kollektorzonenkontaktierungsbereich bedeckt. Dies hat den Vorteil, daß die Herstellung der Emitterelektrode und der Emitterzone gleichzeitig selbstausrichtend mit der Kollektorelektrode und der Kollektorkontaktierungszone erfolgen kann.

Die die Kollektorzone 3 und die Substratzone 3′ enthaltende Hauptfläche der Anordnung wird nun gemäß der Fig. 2 mit einer Photolackschicht bedeckt, aus der die Implantationsmaske M2 photolithographisch erzeugt wird, welche den Basisbereich 51 einschließlich des Emitterbereichs 6 unbedeckt läßt, wie die Fig. 2 veranschaulicht.

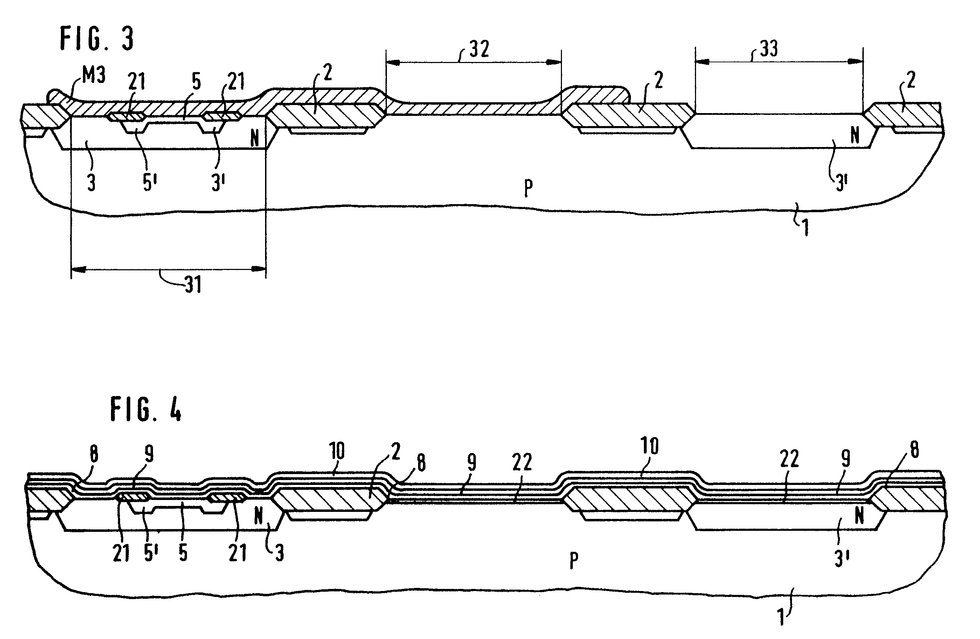

Die Dicke der Oxidationsmaskierungsschicht und damit auch der Oxidationsmaskierungsschichtteil 71 werden derart bemessen, daß diese bei einem Ionenimplantationsprozeß hoher Energie von Dotierungen der Basiszone von diesen durchdrungen und bei einem anderen Ionenimplantationsprozeß niedriger Energie von Dotierungen der Basiszone gegen diese maskiert. Nach einem solchen 2-Stufen-Ionen-Implantationsprozeß und einer späteren Wärmebehandlung zur Aktivierung und Diffusion der Dotierungen wird die in den Fig. 3 bis 7 dargestellte in der Tiefe abgestufte Basiszone mit dem inneren Basiszonenteil 5 und dem äußeren Basiszonenteil 5′ erzeugt. Anschließend erfolgt, wie ebenfalls aus der genannten EP-A-71 665 bekannt ist, eine thermische Oxidation zur Bildung eines den Emitterbereich 6 umgebenden Oxidstreifens 21, wonach die Reste der Oxidationsmaskierungsschicht, insbesondere die des Oxidationsmaskierungsschichtteil 71, entfernt werden.

Die freigelegten Bereiche 32 und 33 der Isolierschicht-Feldeffekttransistoren können nunmehr entsprechend den gewünschten Schwellwerten und entsprechend dem Typ (Anreicherungstyp, Verarmungstyp) mittels Ionenimplantationen dotiert werden, wobei der Bereich 31 des bipolaren Planartransistors mit einer Implantationsmaske, vorzugsweise aus Photolack, geschützt bleibt. Die Fig. 3 zeigt den Zustand vor der Oberflächenimplantation von Dotierungen in dem Beriech 33 des P-Kanal-Feldeffekttransistors. Bei Wahl entsprechender Beschleunigungsenergien kann natürlich auch eine Implantation durch die Oxidationsmaskierungsschicht hindurch erfolgen, die jedoch nach sorgfältiger Entfernung der Photolackreste ebenfalls durch Ätzen entfernt werden muß, so daß auch das Halbleitersubstrat innerhalb des Emitterbereichs freigelegt ist und lediglich die Feldoxidschicht 2 und der Oxidstreifen 21 verbleiben.

Auf die Hauptfläche des Halbleitersubstrats 1 wird nun eine Schichtenfolge aufgebracht, welche zumindest eine zuoberst liegende isolierende Deckschicht 10, vorzugsweise ein Fremdoxid, und eine darunterliegende Silicidschicht 9, vorzugsweise aus Platinsilicid oder Kobaltsilicid, enthält. Zu diesem Zweck wird zunächst eine Schicht 8 aus polykristallinem Silicium aufgebracht, welche vorzugsweise beim Aufbringen bereits Dotierungen vom Leitungstyp der Emitterzone 4 aufweisen kann oder diese vorzugsweise nach dem Aufbringen einer weitgehend reinen polykristallinen Siliciumschicht zugeführt erhält, entweder aus der Gasphase oder mittels Ionenimplantation. Auf diese untere Schicht 8 wird anschließend eine ein Silicid bildende Metallschicht, vorzugsweise aus Platin oder Kobalt, aufgebracht. Entsprechend der Wahl der Dikke der Metallschicht 9 ergibt sich nach entsprechender Erhitzung eine Schichtenfolge, welche entweder noch eine polykristalline Siliciumschicht 8 enthält oder in der diese aufgrund der Reaktion des Metalls mit dem Silicium fehlt. Die Fig. 4 zeigt eine Anordnung mit einer unteren polykristallinen Siliciumschicht 8, einer darauffliegenden Metallschicht 9 und einer Deckschicht 10.

Bei der Herstellung von integrierten Feldeffekttransistoren ist jedenfalls die Dotierung der unteren Siliciumschicht 8 entsprechend dem Verwendungszweck der Elektroden zu wählen, d.h. n-dotierend für den Bereich der Emitterzone des bipolaren Planartransistors, der Sourcezone sowie der Drainzone des N-Kanal-Feldeffekttransistors und ggf. auch des Kontaktes an der Substratzone 3'. Die untere polykristalline Siliciumschicht 8 erhält lediglich im Bereich des Substratkontaktes und im Bereich der Sourcezone und der Drainzone des P-Kanal-Feldeffekttransistors eine p-dotierende Verunreinigung.

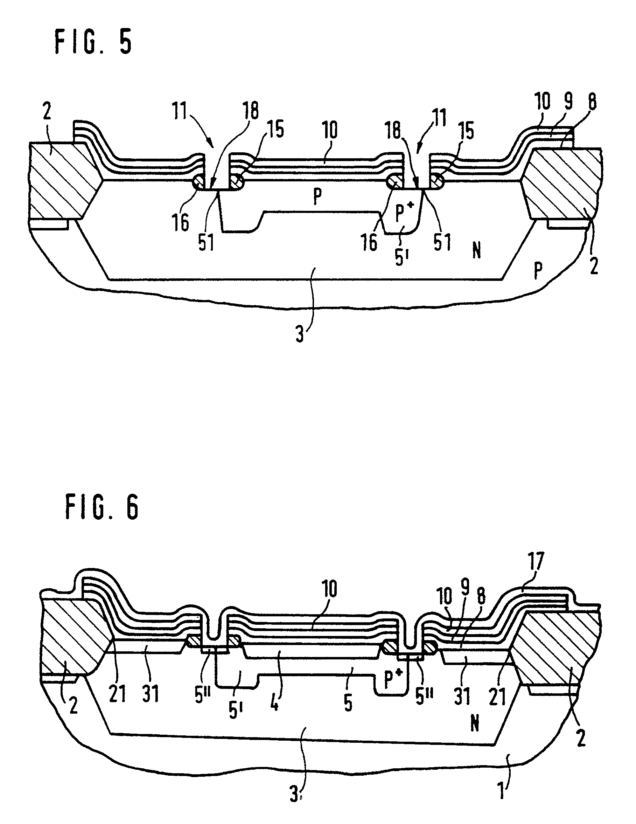

Da die weiteren Herstellungsschritte sich ohne weiteres in Verbindung mit den Herstellungsschritten des bipolaren Planartransistors ergeben, beziehen sich die weiteren Fig. 5 bis 8 lediglich auf die Herstellung des bipolaren Planartransistors entsprechend dem Verfahren nach der Erfindung.

Ausgehend von der in Fig. 4 angegebenen Anordnung mit der bereits vorhandenen Kollektorzone 3 und der Basiszone 5 mit dem äußeren Basiszonenteil 5' wird nach dem Aufbringen der erwähnten Schichtenfolge unter Bildung des Grabens 11 durch die Schichtenfolge 8, 9, 10 hindurch der Oxidstreifen 21 unter Anwendung einer anisotropen Ätzung in einen inneren Streifenteil 15 und einen äußeren Streifenteil 16 geteilt. Anisotrope Ätzverfahren sind in der Halbleitertechnik allgemein bekannt und dienen zur Erzeugung von vertikalen Ätzprofilen, wie es aus der DE-A 32 43 059 bekannt ist. Zu diesem Zwecke wird eine als Ätzmaske verwendete Photolackmaske aufgebracht, in der der Bereich des Grabens ausgespart ist. Es wird dann in einem Reaktor ein Plasmaätzprozeß solange durchgeführt, bis der Halbleiteroberflächenteil 18 am Boden des Grabens um den an diese Halbleiteroberfläche tretenden Teil 51 der PN-Übergangsfläche zwischen der Basiszone 5 und der Kollektorzone 3 freigelegt ist. Dabei wird außer der Emitterelektrode die die Feldoxidschicht 2 überlappende Kollektorelektrode 32 abgegrenzt, wie die Fig. 5 veranschaulicht.

Anschließend erfolgt eine Implantation von Ionen des Leitungstyps der Basiszone 5 in das freiliegende Halbleitermaterial am Boden des Grabens, wobei die genannte Schichtenfolge 8, 9, 10 maskiert. Es wird danach eine Fremdisolierschicht 17 gemäß der Fig. 6 aufgebracht, welche die Oberfläche des Grabens 11, also den Boden und die Seitenflächen, und die restlichen Teile der Deckschicht 10 bedeckt.

Anschließend wird abermals aus der Gasphase eine anisotrope Ätzung derart durchgeführt, daß die Seiteuflächen des Grabens 11, der Rand der Emitterelektrode 42 und der Rand der Kollektorelektrode 32 von Resten der Fremdisolierschicht bedeckt bleiben, die übrigen Teile dieser Fremdisolierschicht aber bis auf die Deckschicht 10 entfernt werden.

Anschließend wird zur Aktivierung und Diffusion der in die Bodenfläche des Grabens implantierten Ionen vom Leitungstyp der Basiszone 5 eine Erhitzungsprozeß auf ausreichend hohe Temperaturen durchgeführt. Es entsteht dabei die Basiskontaktierungszone 5", wie die Fig. 6 und 7 veranschaulichen. An dieser Stelle wird der Zweck der in den Grabenboden implantierten Ionen vom Leitungstyp der Basiszone erkennbar. Würde diese Implantation nämlich unterbleiben, so ergäbe sich ein oberflächlicher Kurzschluß des Basis-Kollektor-Übergangs und eine schlechte Kontaktierung der Basiszone bei dem anschließend erfolgenden Abscheidungsprozeß der Kontaktierungsschicht, aus der die Basiselektrode herausgeätzt wird, welche die Ränder der Kollektorelektrode 32 und der Emitterelektrode 42 mehr oder weniger überlappt.

Die Fig. 8 zeigt in Aufsicht die Anordnung der Fig. 7. Fig. 7 ist ein Querschnitt entlang der Schnittlinie AA' der Fig. 8. In den Fig. 7 und 8 ist die Basiselektrode nicht eingezeichnet, da bei ihrer Formgebung lediglich die Basiskontaktierungszone 5" am Boden des Graben 11 zu kontaktieren ist, sonst aber der weitere Verlauf der an die Basiselektrode anschließenden Leitbahn beliebig ist. Sowohl die Emitterelektrode 61 als auch die Kollektorelektrode 32 sind nämlich von der isolierenden Deckschicht 10 bedeckt, wobei auch die Ränder dieser Elektroden 6 und 32 durch Isolierschichten geschützt sind. Die Zonen der mitintegrierten Feldeffekttransistoren diffundieren aus den Elektroden aus, welche mit ihren anschließenden Leiterbahnen aus der Schichtenfolge 8, 9, 10 bei dem beschriebenen Grabenätzprozeß herausgeätzt wurden.

Vor dem Aufbringen der Schichtenfolge 8, 9, 10 können im übrigen in die freiliegenden Teile des Kollektorbereichs und des Emitterbereichs 6 Ionen vom Leitungstyp der Emitterzone 4 implantiert werden. Dies hat den Vorteil, daß die Dicke und die Dotierungskonzentration in der Emitterzone 4 unabhängig von den Dotierungen in der polykristallinen Siliciumschicht 8 eingestellt werden kann. Im Falle der Herstellung von integrierten Schaltungen ohne P-Kanal-Feldeffekttransistoren genügt es, eine einheitliche polykristaline Siliciumschicht aufzubringen, welche allein Dotierungen vom Leitungstyp der Emitterzone enthält. Sie kann schon beim Aufbringen dotiert sein oder nach dem Aufbringen dotiert werden, beispielsweise durch Ionenimplantation. Aus den abgegrenzten Elektroden werden danach die Emitterzone 4, die Kollektorkontaktierungszone 31 und Sourcezone wie auch Drainzone des mitintegrierten N-Kanal-Feldeffekttransistors ausdiffundiert.

Das Verfahren nach der Erfindung hat den Vorteil, daß sämtliche Elektroden und Leiterbahnen entweder zumindest oberflächlich Silicidschichten enthalten oder aus dem Metall des Basiskontaktes bestehen. Eine durch das Verfahren der Erfindung hergestellte integrierte Schaltung weist also wesentlich geringere Bahnwiderstände auf als eine integrierte Festkörperschaltung, welche durch das Herstellungsverfahren bedingte Leiterbahnen aus polykristallinem Silicium enthält.

## Patentansprüche

1. Verfahren zum Herstellen einer monolithisch integrierten Schaltung mit mindestens einem bipolaren Planartransistor, dessen an einer Hauptfläche eines plattenförmigen Halbleitersubstrats (1) liegende Kollektorzone (3) an dieser Oberflächenseite innerhalb der Öffnung (31) einer Feldoxidschicht (2) einen Kollektorbereich bildet, wobei zur Herstellung von Emitterzone (4) und Basiszone (5,5')

   - der Emitterbereich (6) mit einem Oxidationsmaskierungsschichtteil (71) einer Oxidationsmaskierungsschicht solcher Dicke bedeckt wird, daß diese bei einem Ionen-Implantationsprozeß hoher Energie von Dotierungen der Basiszone (5) von diesen durchdrungen und bei einem anderen Ionen-Implantationsprozeß niedriger Energie von Dotierungen der Basiszone gegen diese maskiert wird, und
   - nach den Implantationsprozessen, welche unter Verwendung einer den Basisbereich definiernden Implantationsmaske (M2) erfolgen, die freiliegende Halbleiteroberfläche unter Bildung eines den Emitterbereich umgebenden Oxidstreifens (21) thermisch oxidiert und danach der Oxidationsmaskierungsschichtteil entfernt wird,

   gekennzeichnet durch folgende Verfahrensschritte:

   a) nach der Entfernung des den Emitterbereich (6) bedeckenden Oxidationsmaskierungsschichtteils (71) wird auf der Hauptfläche des Halbleitersubstrats (1) eine Schichtenfolge aufgebracht, welche eine zuoberst liegende isolierende Deckschicht (10), eine darunterliegende Silicidschicht (9) und ggf. eine polykristalline Si-Schicht (8) enthält,
   b) anschließend wird unter Bildung eines Grabens (11) durch die Schichtenfolge hindurch welches aus der Deckschicht (10), der Silicidschicht (9) und ggf. der polykristallinen Si-Schicht (8) besteht, der Oxidstreifen (21) unter Anwendung einer anisotropen Ätzung in einen inneren Streifenteil (15) und einen äußeren Streifenteil (16) geteilt und der Halbleiteroberflächenteil (18) um den an diese Halbleiteroberfläche tretenden Teil (51) der PN-Übergangsfläche zwischen den äußeren Basiszonenteil (5') und der Kollektorzone (3) freigelegt, wobei außer der Emitterelektrode (42) die die Feldoxidschicht (2) überlappende Kollektorelektrode (32) abgegrenzt wird,
   c) dann erfolgt eine Implantation von Ionen des Leitungstyps der Basiszone (5), wobei die Schichtenfolge (8, 9, 10) maskiert,
   d) danach wird eine Fremdisolierschicht (17) aufgebracht, welche die Oberfläche des Grabens (11), bestehend aus Boden und Seitenflächen, und die restlichen Teile der Deckschicht (10) bedeckt,
   e) anschließend wird aus der Gasphase eine anisotrope Ätzung durchgeführt, so daß die Seitenflächen des Grabens (11), der Rand der Emitterelektrode (42) und der Rand der Kollektorelektrode (32) von Resten der Fremdisolierschicht bedeckt bleiben, die übrigen Teile dieser Fremdisolierschicht aber bis auf die Deckschicht (10) entfernt werden, und
   f) schließlich wird nach Aktivierung und Diffusion der implantierten Ionen vom Leitungstyp der Basiszone (5) zur Kontaktierung der dabei entstehenden Basiskontaktierungszone (5") eine Kontaktierungsschicht aufgebracht, aus der die Basiselektrode unter Anwendung eines photolithographischen Ätzprozesses hergestellt wird.

2. Verfahren nach Anspruch 1, dadurch gekennzeichnet, daß eine polykristalline Siliciumschicht (8) aufgebracht wird, welche Dotierungen vom Leitungstyp der Emitterzone (4) enthält, und daß nach Herausätzen der Emitterelektrode (42) und der Kollektorelektrode (32) eine Emitterzone (4) aus der Emitterelektrode (42) und mindestens eine Kollektorkontaktierungszone (31) aus der Kollektorelektrode (32) diffundiert wird.

3. Verfahren nach Anspruch 1, dadurch gekennzeichnet, daß vor dem Aufbringen der Schichtenfolge (8, 9, 10) in die freiliegenden Teile des Kollektorbereichs (31) und des Emitterbereichs (6) Ionen vom Leitungstyp der Emitterzone (4) implantiert werden.

## Claims

1. Method of making a monolithic integrated circuit comprising at least one bipolar planar transistor whose collector region (3), which lies at a major surface of a wafer-shaped semiconductor substrate (1), forms a collector area at said surface side within the opening (31) of a field-oxide layer (2), wherein, to form the emitter region (4) and the base region (5, 5'),

- the emitter area (6) is covered with a portion (71) of an oxidation mask layer of such a thickness that said oxidation mask layer is penetrated by dopants of the base region (5) in a high-energy ion-implantation process and masked against dopants of the base region in a low-energy ion-implantation process, and
- after the ion-implantation processes, which are carried out using an implantation mask (M2) defining the base area, the exposed semiconductor surface is thermally oxidized forming an oxide stripe (21) surrounding the emitter area, whereafter the portion (71) of the oxidation mask layer is removed,

characterized by the following steps:

a) After removal of the portion (71) of the oxidation mask layer covering the emitter area (6), said major surface of the semiconductor substrate (1) is provided with a layer sequence consisting of an insulating top layer (10), an underlying silicide layer (9), and, if necessary, a polycrystalline Si layer (8);
b) then, the oxide stripe (21) is divided into an inner portion (15) and an outer portion (16) using an anisotropic etching technique, thereby forming a moat (11) through the layer sequence consisting of the top layer (10), the silicide layer (9), and, if necessary, the polycrystalline Si layer (8), and exposing that portion (51) of the PN junction between the outer base-region portion (5') and the collector region (3) which extends to said semiconductor surface, whereby in addition to the emitter electrode (42), the collector electrode (32') is defined, which overlaps the field-oxide layer (2);
c) then, ions of the conductivity type of the base region (5) are implanted, with the layer sequence (8, 9, 10) working as a mask;
d) then, an insulating layer (17) is deposited which covers the surface of the moat (11), consisting of bottom and side surfaces, and the remaining portions of the top layer (10);
e) then, anisotropic etching is carried out from the gas phase, so that the side surfaces of the moat (11), the rim of the emitter electrode (42), and the rim of the collector electrode (32') remain covered by remainders of the insulating layer, while the remaining portions of said insulating layer are removed down to the top layer (10), and
f) finally, after activation and diffusion of the implanted ions of the conductivity type of the base region (5), a contact layer for contacting the resulting base contact region (5'') is deposited from which the base electrode is formed using a photolithographic etching process.

2. A method as claimed in claim 1, characterized in that a polycrystalline silicon layer (8) containing dopants of the conductivity type of the emitter region (4) is deposited, and that, after said polycrystalline silicon layer (8) has been etched to define the emitter electrode (42) and the collector electrode (32'), the emitter region (4) is diffused out of the emitter electrode (42), and at least one collector contact region (31) is diffused out of the collector electrode (32).

3. A method as claimed in claim 1, characterized in that prior to the deposition of the layer sequence (8, 9, 10), ions of the conductivity type of the emitter region (4) are implanted into the exposed portions of the collector area and the emitter area (6).

**Revendications**

1. Procédé pour fabriquer un circuit intégré monolithique comportant au moins un transistor bipolaire planar, dont la zone de collecteur (3), qui est située sur une surface principale d'un substrat semiconducteur en forme de plaque (1), forme, au niveau de cette surface et à l'intérieur de l'ouverture (31) d'une couche d'oxyde de champ (2), une zone de collecteur, et selon lequel pour fabriquer une zone d'émetteur (4) et une zone de base (5,5'),
   - on recouvre la zone d'émetteur (6) par une partie (71) d'une couche de masquage contre l'oxydation, possédant une épaisseur telle que, lors d'un procédé d'implantation ionique avec une énergie élevée de substances dopantes dons la zone de base (5), la couche de masquage est traversée par ces substances dopantes, et lors d'un autre processus d'implantation ionique avec une faible énergie de substance dopante, la zone de base est protégée vis-à-vis de ces substances dopantes, et
   - après les processus d'implantation, qui sont réalisés moyennant l'utilisation d'un masque d'implantation (M2) définissant la zone de base, on réalise une oxydation thermique de la surface semiconductrice à nu, avec formation d'une bande d'oxyde (21) entourant la zone d'émetteur, puis on élimine la partie de la couche de masquage contre l'oxydation, caractérisé par les étapes opératoires suivantes :

a) après élimination de la partie (71) de la couche de masquage contre l'oxydation, qui recouvre la zone d'émetteur (6), on dépose sur la surface principale du substrat semiconducteur (1) une succession de couches, qui contient une couche isolante supérieure de revêtement (10) et une couche sous-jacente de siliciure (9) et éventuellement une couche de Si polycristallin (8),

b) puis, moyennant la formation d'un sillon (11) à travers la succession de couches, constituée par la couche de revêtement (10), la couche de siliciure (9) et éventuellement la couche de Si polycristallin (8), on subdivise la bande d'oxyde (21), moyennant l'utilisation d'une corrosion anisotrope, en une partie intérieure (15) et une partie extérieure (16), et on met à nu l'élément (18) de la surface semiconductrice autour de la partie (51), qui est formée au niveau de cette surface semiconductrice, de la surface de la jonction PN entre la partie extérieure (5') de la zone de base et la zone de collecteur (3), l'électrode de collecteur (32) recouvrant la couche d'oxyde de champ (2) étant délimitée, en dehors de l'électrode d'émetteur (42),

c) puis on effectue une implantation d'ions possédant le type de conductivité de la zone de base (5), en réalisant un masquage de la succession de couches (8,9,10),

d) on dépose ensuite une couche isolante étrangère (17), qui recouvre la surface du sillon (11), qui est constitué par un fond et des surfaces latérales, et les parties restantes de la couche de revêtement (10),

e) ensuite, on réalise à partir de la phase gazeuse une corrosion anisotrope de sorte que les surfaces latérales du sillon (11), le bord de l'électrode d'émetteur (42) et le bord de l'électrode de collecteur (32) restent recouverts par des restes de la couche isolante étrangère, tandis que les autres parties de cette couche isolante étrangère sont éliminées jusqu'au niveau de la couche de revêtement (10), et

f) enfin, après activation et diffusion des ions implantés possédant le type de conductivité de la zone de base (5), pour l'établissement du contact avec la zone alors obtenue (5") du contact de base, on dépose une couche de contact, à partir de laquelle on forme l'électrode de base en utilisant un procédé de corrosion photolithographique.

2. Procédé suivant la revendication 1, caractérisé par le fait qu'on dépose une couche de silicium polycristallin (8), qui contient des substances dopantes possédant le type de conductivité de la zone d'émetteur (4), et qu'après avoir dégagé par corrosion l'électrode d'émetteur (42) et l'électrode de collecteur (32), on fait diffuser une zone d'émetteur (4) à partir de l'électrode d'émetteur (42) et au moins une zone de contact de collecteur (31) à partir de l'électrode de collecteur (32).

3. Procédé selon la revendication 1, caractérisé en ce qu'avant le dépôt de la succession de couches (8,9,10) on implante, dans les parties à nu de la zone de collecteur (31) et de la zone d'émetteur (6), des ions possédant le type de conductivité de la zone d'émetteur (4).

FIG. 1

FIG. 2

EP 0 270 703 B1

# FIG. 3

# FIG. 4

EP 0 270 703 B1

FIG. 5

FIG. 6

# FIG. 7

# FIG. 8